# EUROPEAN PATENT APPLICATION

(11) **EP 2 879 192 A1**
(43) Date of publication of application: **03.06.2015**
(21) Application number: 13822863.0
(22) Date of filing: 08.07.2013
(51) Int. Cl.: H01L 31/042

(54) **SEALING FILM FOR SOLAR CELLS, SOLAR CELL MODULE, AND METHOD FOR SELECTING SEALING FILM FOR SOLAR CELLS**

(30) Priority: 25.07.2012 JP 2012164414; 25.07.2012 JP 2012164416
(71) Applicant: Bridgestone Corporation, Tokyo 104-8340 (JP)
(72) Inventor: NAGAI Toshiro, Yokohama-shi, Kanagawa 244-8510 (JP); KUWANO Koji, Yokohama-shi, Kanagawa 244-8510 (JP)
(74) Representative: Oxley, Robin John George
(86) International application number: PCT/JP2013/068621
(87) International publication number: WO 2014/017282

(57) **Abstract**

A sealing film for solar cells for a solar cell module constituting a solar power generation system with a system voltage of 600 V or more, and is capable of suppressing the generation of PIDphenomenon; and a solar cell module are provided. Such sealing film for solar cells consists of a crosslinkable curable film of a composition containing an ethylene-polar monomer copolymer and a crosslinking agent. The film is characterized in that the product (ρv·t) of a volume resistivity (pv [Ω·cm]) at 25°C (JIS K6911-1995) of the sealing film after crosslinking curing and a thickness (t [cm]) of the sealing film for solar cells is 5.0×10¹³ or more; a solar cell module containing the sealing film for solar cells; and a method for selecting a sealing film for solar cells, which is characterized by selecting a sealing film for solar cells having the above-mentioned ρv·t.

## Description

### Technical Field

The present invention relates to a sealing film for solar cells containing an ethylene-polar monomer copolymer as the main component, particularly relates to a sealing film for solar cells capable of suppressing the generation of potential induced degradation (PID) phenomenon in a solar cell module of a solar power generation system with a system voltage of 600 V or more, and a solar cell module.

### Background Art

Conventionally, in view of effective utilization of resources, prevention of environmental pollution, and the like, solar cells in which sunlight is directly converted to electrical energy have been widely used. In recent years, a large-scale solar power generation system called mega solar with an output of 1 MW or more has been increased, a high system voltage is required for reasons of efficiency and the like in the transmission system, and mega solar with a system voltage of 600 V or more, in particular, mega solar with a system voltage of 1,000 V or more has been also constructed.

Recently, in such a solar power generation system with a high system voltage, there becomes a problem that the performance degradation of solar cell module called potential induced degradation (PID) phenomenon, which has not been observed in the conventional solar cell modules, is generated. PID phenomenon is phenomenon in which polarization of electric charge is generated in an internal circuit of a solar cell module, and the output is significantly decreased by the prevention of the electrons from moving inside a cell. This is considered to be due to a cause that in the solar power generation system with a higher system voltage, a high potential difference is generated between the earthed frame and the internal circuit of a solar cell module, and to which an external factor such as humidity, temperature, and the like acts, and leakage current is generated between the internal circuit of the module and the frame. The PID phenomenon is generated due to the interaction of each member of a solar cell module, therefore, the conditions and the like to suppress the generation have not been clarified yet.

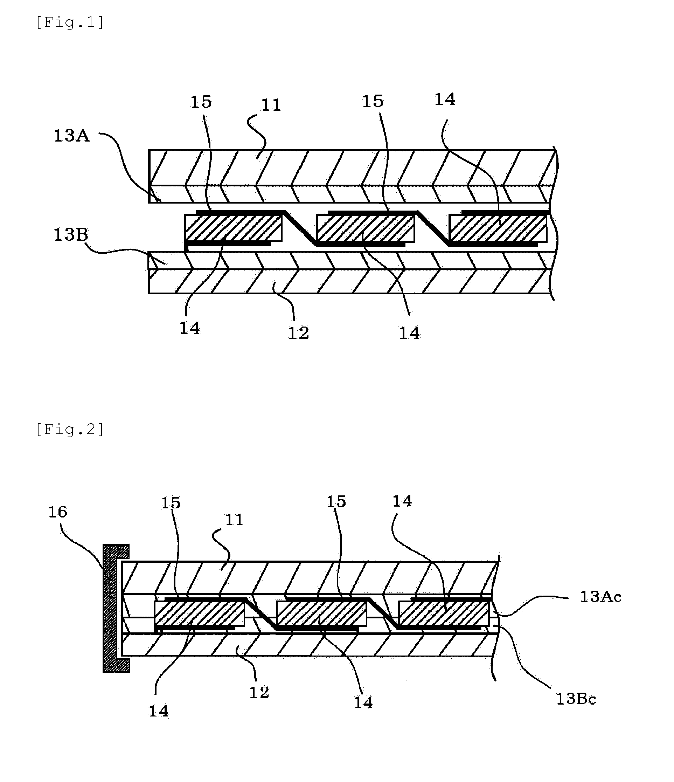

As shown in Fig. 1, in general, a solar cell module is produced as follows: a front side transparent protective member 11 composed of a glass substrate and the like, a front side sealing film 13A, cells for solar cell 14 such as a silicon crystal-based power generation element, a back side sealing film 13B, and a back side protective member (back cover) 12 are laminated in this order; the degassing is performed under reduced pressure; and then the front side sealing film 13A and the back side sealing film 13B are crosslinked and cured by heat pressing to bond and integrate with each other.

In order to obtain high electrical output, a solar cell module is in general used by connecting multiple cells for solar cell 14 with an interconnector 15, and in order to ensure the insulation of the cells for solar cell 14, the sealing films 13A and 13B, which have high insulation, are used.

Further, a thin film solar cell module of thin film silicon-based, and thin film amorphous silicon-based solar cells, copper indium selenide (CIS)-based solar cells, and the like have also been developed, and in this case, for example, a power generation element layer such as a semiconductor layer is formed on the surface of a transparent substrate such as a glass substrate, and a polyimide substrate by a chemical vapor deposition method and the like, and on which a sealing film and the like are laminated, and bonded and integrated to produce a thin film solar cell module.

Conventionally, as the sealing film used for the solar cell module described above, a film consisting of an ethylene-polar monomer copolymer such as an ethylene-vinyl acetate copolymer (hereinafter, also referred to as EVA), an ethylene ethyl acrylate copolymer (EEA), and the like is used. In particular, an EVA film is preferably used because of being inexpensive and having high transparency. Further, in the ethylene-polar monomer copolymer for a sealing film, in order to improve the film strength, durability, weatherability, adhesiveness, and the like of the sealing film, a crosslinking agent such as an organic peroxide to improve the crosslinking density, and the like are mixed as needed (for example, Patent Literature 1).

### Citation List

### Patent Literature

Patent Literature 1: Japanese Patent Application Laid-Open No. H06-177412

### Summary of Invention

### Technical Problem

As described above, it is extremely important in the solar power generation system with a high system voltage to suppress the generation of PID phenomenon to realize the stable power generation output. Further, the PID phenomenon is generated due to the interaction of each member of a solar cell module, therefore, it is considered to be important also to select a sealing film for solar cells to seal cells for solar cell or a power generation element for thin film solar cells (these are also collectively referred to as a solar cell element in the present invention) in order to suppress the generation of the PID phenomenon.

Therefore, an obj ect of the present invention is to provide a sealing film for solar cells used for a solar cell module constituting a solar power generation system with a system voltage of 600 V or more, in which generation of PID phenomenon can be suppressed, and a solar cell module.

Further, an object of the present invention is to provide a method for selecting a sealing film for solar cells capable of suppressing the above-mentioned generation of PID phenomenon.

### Solution to Problem

The present inventors investigated various conditions in order to select a sealing film for solar cells capable of suppressing the above-mentioned generation of PID phenomenon, and found that the PID phenomenon is hardly generated if the sealing film for solar cells has high insulation with a predetermined level or more, and thus have achieved the present invention.

That is, the above-mentioned object is achieved by a sealing film for solar cells that is used for a solar cell module constituting a solar power generation system with a system voltage of 600 V or more, which consists of a crosslinkable and curable film of a composition containing an ethylene-polar monomer copolymer and a crosslinking agent, and is characterized in that the product (ρv·t) of a volume resistivity (pv [Ω·cm]) at a temperature of 25°C (in accordance with JIS K6911-1995) of a sealing film for solar cells after crosslinking curing and a thickness (t [cm]) of the sealing film for solar cells after crosslinking curing is 5.0 × 10¹³ or more. The value of ρv·t is preferably 7.0 × 10¹³ or more, and more preferably 1.0 × 10¹⁴ or more. In order to suppress the generation of PID phenomenon, the higher the value of ρv·t is, the better, and the upper limit is not particularly limited. However, in consideration of the transparency, workability, and the like of the sealing film for solar cells, the value of ρv·t is preferably 1.0 × 10¹⁶ or less.

The preferred embodiment of the sealing film for solar cells according to the present invention is as follows.

(1) The system voltage of the solar power generation system is 1,000 V or more. The solar power generation system is a solar power generation system in which PID phenomenon is more easily generated, and the sealing film for solar cells of the present invention is more effective.
(2) The ethylene-polar monomer copolymer is an ethylene-vinyl acetate copolymer. Inexpensive and excellent in the transparency.
(3) The crosslinking agent is an organic peroxide. A sealing film that is excellent in the adhesiveness, transparency, and the like can be realized.
(4) The composition further contains a crosslinking auxiliary agent and/or a silane coupling agent. A sealing film that is more excellent in the adhesiveness can be realized.
(5) The sealing film for solar cells after crosslinking curing has a thickness of 0.4 to 1.0 mm. Excellent in the workability.
(6) The sealing film for solar cells is a front side sealing film being disposed between a solar cell element and a front side transparent protective member of a solar cell module, and used for sealing a solar cell element.

As shown in Examples described below, a sealing film for solar cells of the present invention can effectively suppress the generation of PID phenomenon in a case of being used for a front side sealing film that seals the photoreception surface side of a solar cell element. In addition, in the present invention, the side which is irradiated with the light of a solar cell element (photoreception surface side) is referred to as "front side", and an opposite surface side to the photoreception surface of a solar cell element is referred to as "back side".

Further, the above-mentioned object is achieved by a solar cell module, which constitutes a solar power generation system with a system voltage of 600 V or more, has a structure of disposing a sealing film for solar cells between a solar cell element and a front side transparent protective member and/or a back side protective member, and of sealing the solar cell element by the sealing film for solar cells, the sealing film for solar cells consists of a crosslinked cured film of a composition containing an ethylene-polar monomer copolymer and a crosslinking agent, and characterized in that the product (ρv·t) of a volume resistivity (pv [Ω·cm]) (in accordance with JIS K6911-1995) of a sealing film for solar cells at a temperature of 25°C (after crosslinking curing) and a thickness (t [cm]) of the sealing film for solar cells (after crosslinking curing) is 5.0 × 10¹³ or more. The value of ρv·t of the sealing film for solar cells after crosslinking is preferably 7.0 × 10¹³ or more, and more preferably 1.0×10¹⁴ or more. In order to suppress the generation of PID phenomenon, the higher the value of ρv·t is, the better, and the upper limit is not particularly limited. However, in consideration of the transparency, workability, and the like of the sealing film for solar cells, the value of ρv·t is preferably 1.0 × 10¹⁶ or less.

The preferred embodiment of the solar cell module according to the present invention is as follows.

(1) The system voltage of the solar power generation system is 1,000 V or more. The solar power generation system is a solar power generation system in which PID phenomenon is more easily generated, and the solar cell module of the present invention is more effective.
(2) The solar cell module has a structure of disposing the sealing film for solar cells between the solar cell element and the front side transparent protective member as a front side sealing film, and of sealing the solar cell element by the front side sealing film. As shown in Examples described below, in the solar cell module of the present invention, the above-mentioned sealing film for solar cells having high insulation can effectively suppress the generation of PID phenomenon in a case of being used for a front side sealing film that seals the photoreception surface side of a solar cell element.
(3) The ethylene-polar monomer copolymer is an ethylene-vinyl acetate copolymer. A solar cell module having a sealing film that is inexpensive and excellent in the transparency can be realized.
(4) The crosslinking agent is an organic peroxide. A solar cell module having a sealing film that is excellent in the adhesiveness, the transparency, and the like can be realized.
(5) The composition of the sealing film for solar cells further contains a crosslinking auxiliary agent and/or a silane coupling agent. A solar cell module having a sealing film that is more excellent in the adhesiveness can be realized.
(6) The sealing film for solar cells after crosslinking curing has a thickness of 0.4 to 1.0 mm. A solar cell module, which is easy to be produced, can be realized by a sealing film being excellent in the workability.

Further, the above-mentioned object is achieved by a method for selecting a sealing film for solar cells that is a sealing film for solar cells obtained by crosslinking curing a composition containing an ethylene-polar monomer copolymer and a crosslinking agent, and is used for a solar cell module constituting a solar power generation system with a system voltage of 600 V or more, which is characterized by measuring a volume resistivity of (pv [Ω·cm]) (in accordance with JIS K6911-1995) of a sealing film for solar cells at a temperature of 25°C after crosslinking curing, and a thickness (t [cm]) of the sealing film for solar cells, and selecting a sealing film for solar cells having the product (ρv·t) of the volume resistivity (pv) and the thickness (t) of 5.0 × 10¹³ or more. As a result, in a solar cell module constituting a solar power generation system with a high system voltage, the sealing film for solar cells, which has high insulation suitable for the suppression of the generation of PID phenomenon, can easily be selected.

### Advantageous Effects of Invention

According to the present invention, in a solar cell module constituting a solar power generation system with a high system voltage, a sealing film for solar cells capable of suppressing the generation of PID phenomenon can be provided. Further, a solar cell module having the sealing film for solar cells can be provided. As a result, these can contribute to the stable power generation output in a large-scale solar power generation system.

### Brief Description of Drawings

Fig. 1 is an outline sectional view of a laminated body at the time of producing a common solar cell module.
Fig. 2 is an outline sectional view of a common solar cell module.

### Description of Embodiments

A sealing film for solar cells of the present invention is a sealing film for solar cells used for a solar cell module constituting a solar power generation system with a system voltage of 600 V or more. Further, the sealing film for solar cells consists of a crosslinkable and curable film of a composition containing an ethylene-polar monomer copolymer and a crosslinking agent, which is characterized in that the product (ρv·t) of a volume resistivity (pv [Ω·cm]) (in accordance with JIS K6911-1995) of a sealing film for solar cells at a temperature of 25°C after crosslinking curing and a thickness (t [cm]) of the sealing film for solar cells after crosslinking curing is 5.0 × 10¹³ or more. As long as the sealing film for solar cells has such high insulation, the generation of PID phenomenon, which becomes a problem in a solar cell module constituting a solar power generation system with a high system voltage, can be suppressed. The cause is not clear, however, it is considered that generation of the leakage current between the internal circuit of the module and the earthed frame is suppressed by the enhancement of the insulation between the solar cell element and the protective member in the solar cell module to the predetermined level or more, and as a result, the polarization of charge in the internal circuit can be prevented.

The value of ρv·t is preferably 7.0 × 10¹³ or more, and more preferably 1.0 × 10¹⁴ or more. In order to suppress the generation of PID phenomenon, the higher the value of ρv·t is, the better, and the upper limit is not particularly limited. However, in consideration of the transparency, workability, and the like of the sealing film for solar cells, the value of ρv·t is preferably 1.0 × 10¹⁶ or less.

The higher the system voltage of a solar power generation system is, the higher the potential difference between the internal circuit of the module and the earthed frame is, therefore, the PID phenomenon is easy to be generated. Accordingly, recently, in a case of a solar power generation system with a system voltage of 1,000 V or more, which has been constructed, the possibility of generation of the PID phenomenon becomes high. The sealing film for solar cells of the present invention can suppress the generation of PID phenomenon even the potential difference between frames is high, therefore, which is preferably used for a solar cell module constituting a solar power generation system with a system voltage of 1,000 V or more. The upper limit of system voltage of a solar power generation system is not particularly limited, however, is 1,500 to 2,000 V in a current system.

Hereinafter, the sealing film for solar cells of the present invention will be explained in more detail.

The value of ρv·t of the sealing film for solar cells depends on the formulation of the composition to form the sealing film, the crosslinking curing conditions, and the thickness of the sealing film. Various materials of the composition to form a sealing film for solar cells with the above-mentioned value of ρv·t are shown in the below.

### [Ethylene-polar monomer copolymer]

In the present invention, examples of the polar monomer of an ethylene-polar monomer copolymer include an unsaturated carboxylic acid, a salt thereof, an ester thereof, an amide thereof, vinyl ester, and carbon monoxide. More specifically, the examples include one kind or two or more kinds of an unsaturated carboxylic acid such as acrylic acid, methacrylic acid, fumaric acid, itaconic acid, monomethyl maleic acid, monoethyl maleic acid, maleic anhydride, and itaconic acid anhydride, and of which a salt of a univalent metal such as lithium, sodium, and potassium and a salt of a polyvalent metal such as magnesium, calcium, and zinc; an unsaturated carboxylic ester such as methyl acrylate, ethyl acrylate, isopropyl acrylate, isobutyl acrylate, n-butyl acrylate, isooctyl acrylate, methyl methacrylate, ethyl methacrylate, isobutyl methacrylate, and dimethyl maleate; a vinyl ester such as vinyl acetate and vinyl propionate; carbon monoxide; and sulfur dioxide.

More specifically, examples of the ethylene-polar monomer copolymer include an ethylene-unsaturated carboxylic acid copolymer such as an ethylene-acrylic acid copolymer, and an ethylene-methacrylic acid copolymer; an ionomer in which the whole or part of the carboxyl group of the ethylene-unsaturated carboxylic acid copolymer is neutralized with the above-mentioned metal; an ethylene-unsaturated carboxylic acid ester copolymer such as an ethylene-methyl acrylate copolymer, an ethylene-ethyl acrylate copolymer, an ethylene-methyl methacrylate copolymer, an ethylene-isobutyl acrylate copolymer, and an ethylene-n-butyl acrylate copolymer; an ethylene-unsaturated carboxylic acid ester-unsaturated carboxylic acid copolymer such as an ethylene-isobutyl acrylate-methacrylic acid copolymer, and an ethylene-n-butyl acrylate-methacrylic acid copolymer, and an ionomer in which the whole or part of the carboxyl group is neutralized with the above-mentioned metal; and an ethylene-vinyl ester copolymer such as an ethylene-vinyl acetate copolymer, as a representative example.

In the present invention, the ethylene-polar monomer copolymer is particularly preferably an ethylene-vinyl acetate copolymer (EVA). According to this, a sealing film for solar cells, which is inexpensive, and more excellent in the transparency and the workability, can be realized. The content of the ethylene-vinyl acetate copolymer is preferably 20 to 35% by mass, more preferably 22 to 30% by mass, and particularly preferably 24 to 28% by mass based on the EVA. When the content of the vinyl acetate in EVA is extremely low, the sealing film to be obtained becomes hard, and there may be a risk that the transparency of the sealing film becomes low. Further, when the content is extremely high, the hardness of the sealing film is insufficient, and there may be a case where the workability becomes low.

In the sealing film for solar cells of the present invention, a polyvinyl acetal-based resin (for example, polyvinyl formal, polyvinyl butyral (PVB resin), and modified PVB), and a vinyl chloride resin may further be secondarily used in addition to the ethylene-polar monomer copolymer. In this case, PVB is particularly preferred.

### [Crosslinking agent]

In the sealing film for solar cells of the present invention, the crosslinking agent can form a crosslinking structure of an ethylene-polar monomer copolymer, and can also improve the strength, the adhesiveness, and the durability with the enhancement of the insulation of the sealing film. As the crosslinking agent, an organic peroxide, or a photopolymerization initiator is preferably used. Among them, an organic peroxide is preferably used because a sealing film for solar cells in which the adhesion, the transparency, the moisture resistance, and the temperature dependency of the penetration resistance have improved is obtained. As the organic peroxide, any organic peroxide can be used as long as being decomposed at a temperature of 100°C or more and generating radicals.

The organic peroxide is generally selected in consideration of the film forming temperature, the adjustment conditions of a composition, the curing temperature, the heat resistance of an adherend, and the storage stability, in particular, an organic peroxide with a 10-hour half-life decomposition temperature of 70°C or more is preferred. The organic peroxide may be used singly or two or more kinds in combination.

Examples of the organic peroxide include, from the viewpoint of the processing temperature and storage stability of resin, for example, a benzoyl peroxide-based curing agent, tert-hexyl peroxypivalate, tert-butyl peroxypivalate, 3,5,5-trimethylhexanoyl peroxide, di-n-octanoyl peroxide, lauroyl peroxide, stearoyl peroxide, 1,1,3,3-tetramethylbutyl peroxy-2-ethylhexanoate, succinic acid peroxide, 2,5-dimethyl-2,5-di(tert-butyl peroxy)hexane, 2,5-dimethyl-2,5-di(2-ethylhexanoyl peroxy)hexane, 1-cyclohexyl-1-methylethyl peroxy-2-ethylhexanoate, tert-hexyl peroxy-2-ethylhexanoate, 4-methylbenzoyl peroxide, tert-butyl peroxy-2-ethylhexanoate, m-toluoyl + benzoyl peroxide, benzoyl peroxide, 1,1-bis(tert-butyl peroxy)-2-methylcyclohexane, 1,1-bis(tert-hexyl peroxy)-3,3,5-trimethylcyclohexane, 1,1-bis(tert-hexyl peroxy)cyclohexane, 1,1-bis(tert-butyl peroxy)-3,3,5-trimethylcyclohexane, 1,1-bis(tert-butyl peroxy) cyclohexane, 2,2-bis(4,4-di-tert-butyl peroxy cyclohexy)propane, 1,1-bis(tert-butyl peroxy)cyclododecane, tert-hexyl peroxyl isopropyl monocarbonate, tert-butyl peroxyl maleic acid, tert-butyl peroxy-3,3,5-trimethylhexane, tert-butyl peroxyl laurate, 2,5-dimethyl-2,5-di(methyl benzoyl peroxy)hexane, tert-butyl peroxy isopropyl monocarbonate, tert-butyl peroxy-2-ethylhexylmonocarbonate, tert-hexylperoxybenzoate, and 2,5-di-methyl-2,5-di(benzoyl peroxy)hexane.

As the benzoyl peroxide-based curing agent, any benzoyl peroxide-based curing agent can be used as long as being decomposed at a temperature of 70°C or more and generating radicals, however, a benzoyl peroxide-based curing agent with a 10-hour half-life decomposition temperature of 70°C or more is preferred, and a benzoyl peroxide-based curing agent can be appropriately selected in consideration of the adjustment conditions, the film forming temperature, the curing (bonding) temperature, the heat resistance of an adherend, and the storage stability. Examples of the usable benzoyl peroxide-based curing agent include, for example, benzoyl peroxide, 2,5-dimethylhexyl-2,5-bis peroxy benzoate, p-chlorbenzoyl peroxide, m-toluoyl peroxide, 2,4-dichlorobenzoyl peroxide, and t-butylperoxy benzoate.

As the organic peroxide, in particular, 2,5-dimethyl-2,5-di(tert-butyl peroxy)hexane, and tert-butyl peroxy-2-ethylhexyl monocarbonate are preferred. According to this, a sealing film for solar cells being excellent in the insulation is obtained.

The content of the organic peroxide is particularly 0.1 to 2 parts by mass, more preferably 0.5 to 2 parts by mass, and particularly preferably 1 to 2 parts by mass based on 100 parts by mass of the ethylene-polar monomer copolymer. When the content of the organic peroxide is low, there may be a case where a sealing film with the above-mentioned value of ρv·t is not obtained, and when the content is extremely high, there may be a risk that the compatibility with the ethylene-polar monomer copolymer becomes poor.

Further, as the photopolymerization initiator, any known photopolymerization initiator can be used, however, a photopolymerization initiator with favorable storage stability after the mixing is desired. As such a photopolymerization initiator, for example, an acetophenone-based photopolymerization initiator such as 2-hydroxy-2-methyl-1-phenylpropane-1-one, 1-hydroxycyclohexyl phenyl ketone, and 2-methyl-1-(4-(methylthio)phenyl)-2-morpholinopropan-1; a benzoin-based photopolymerization initiator such as benzyl dimethyl ketal; a benzophenone-based photopolymerization initiator such as benzophenone, 4-phenylbenzophenone, and hydroxybenzophenone; a thioxanthone-basedphotopolymerization initiator such as isopropylthioxanthone, and 2-4-diethylthioxanthone; methylphenyl glyoxylate as other special one; and the like can be used. Particularly preferably 2-hydroxy-2-methyl-1-phenylpropane-1-one, 1-hydroxycyclohexyl phenyl ketone, and 2-methyl-1-(4-(methylthio)phenyl)-2-morpholinopropan-1, and benzophenone are included. These photopolymerization initiators can be used as a mixture with a benzoic acid-based photopolymerization initiator such as 4-dimethylaminobenzoic acid, or one kind or two or more kinds of known and common photopolymerization initiators such as the tertiary amines at an arbitrary ratio as needed. Further, the photopolymerization initiator can be used singly or two or more kinds in combination.

The content of the photopolymerization initiator is preferably 0.5 to 5.0 parts by mass based on 100 parts by mass of the ethylene-polar monomer copolymer.

### [Crosslinking auxiliary agent]

As to the sealing film for solar cells of the present invention, in the composition thereof, a crosslinking auxiliary agent may further be contained as needed. The crosslinking auxiliary agent can improve the gel rate of the ethylene-polar monomer copolymer, and the adhesiveness and durability of the sealing film, and further can improve the insulation.

The content of the crosslinking auxiliary agent is generally 10 parts by mass or less, preferably 0.1 to 5 parts by mass, and more preferably 0.5 to 2.5 parts by mass based on 100 parts by mass of the ethylene-polar monomer copolymer. According to this, a sealing film being excellent in the adhesiveness and the insulation is obtained.

Examples of the crosslinking auxiliary agent (a compound having a radical polymerizable group as a functional group) include a monofunctional or bifunctional crosslinking auxiliary agent of (meth) acrylic ester (for example, NK ester) in addition to a trifunctional crosslinking auxiliary agent such as triallyl cyanurate, and triallyl isocyanurate. Among them, triallyl cyanurate, and triallyl isocyanurate are preferred, and particularly triallyl isocyanurate is preferred.

### [Adhesion improver]

As to the sealing film for solar cells of the present invention, in the composition thereof, an adhesion improver may further be contained as needed. As the adhesion improver, a silane coupling agent can be used. According to this, a sealing film for solar cells having excellent adhesion can be formed. Examples of the silane coupling agent include γ-chloropropyl trimethoxy silane, vinyltriethoxysilane, vinyltris (β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane, and N-β-(aminoethyl)-γ-aminopropyltrimethoxysilane. These silane coupling agents may be used alone or two or more kinds in combination. Among them, γ-methacryloxypropyltrimethoxysilane is particularly preferably included.

The content of the silane coupling agent is preferably 0.1 to 0.7 part by mass, and particularly preferably 0.3 to 0.65 part by mass based on 100 parts by mass of the ethylene-polar monomer copolymer.

### [Others]

As to the sealing film for solar cells of the present invention, in the composition thereof, various kinds of additives including a plasticizer, anacryloxy group-containing compound, a methacryloxy group-containing compound and/or an epoxy group-containing compound may further be contained as needed in order to improve or adjust the various properties (mechanical strength, optical properties including transparency, heat resistance, light resistance, crosslinking rate, and the like) of the sealing film.

The plasticizer is not particularly limited, however, in general, an ester of a polybasic acid, and an ester of a polyhydric alcohol are used. Examples of the plasticizer include dioctyl phthalate, dihexyl adipate, triethylene glycol-di-2-ethyl butyrate, butyl sebacate, tetraethylene glycol diheptanoate, and triethylene glycol dipelargonate. The plasticizer may be used singly or two or more kinds in combination. The content of the plasticizer is preferably in the range of 5 parts by mass or less based on 100 parts by mass of the ethylene-polar monomer copolymer.

The acryloxy group-containing compound and the methacryloxy group-containing compound are generally a derivative of acrylic acid or methacrylic acid, and examples of the compound include an ester of acrylic acid or methacrylic acid, and an amide of acrylic acid or methacrylic acid. Examples of the ester residue include a linear alkyl group such as methyl, ethyl, dodecyl, stearyl, and lauryl, a cyclohexyl group, a tetrahydrofurfurylgroup, an aminoethyl group, a2-hydroxyethyl group, a 3-hydroxypropyl group, and a 3-chloro-2-hydroxypropyl group. Examples of the amide include diacetone acrylamide. Further, an ester of a polyhydric alcohol such as ethylene glycol, triethylene glycol, polypropylene glycol, polyethylene glycol, trimethylol propane, and pentaerythritol with an acrylic acid or a methacrylic acid can also be included.

Examples of the epoxy-containing compound include triglycidyl tris(2-hydroxyethyl)isocyanurate,neopentyl glycol diglycidyl ether, 1, 6-hexandiol diglycidyl ether, allyl glycidyl ether, 2-ethylhexyl glycidyl ether, phenyl glycidyl ether, phenol(ethyleneoxy)₅glycidyl ether, p-t-butyl phenyl glycidyl ether, adipic acid diglycidyl ester, phthalic acid diglycidyl ester, glycidyl methacrylate, and butyl glycidyl ether.

The acryloxy group-containing compound, the methacryloxy group-containing compound or the epoxy group-containing compound is contained in an amount of generally preferably 0.5 to 5.0 parts by mass, and particularly preferably 1.0 to 4.0 parts by mass based on 100 parts by mass of the ethylene-polar monomer copolymer.

Further, as to the sealing film for solar cells of the present invention, in the composition thereof, an ultraviolet absorber, a light stabilizer, and an age resistermaybe contained. With the containing of an ultraviolet absorber, the ethylene-polar monomer copolymer can be suppressed from the degradation under the influence of irradiated light or the like, and a sheet can be suppressed from turning yellow. The ultraviolet absorber is not particularly is limited, and examples of the ultraviolet absorber preferably include a benzophenone-based ultraviolet absorber such as 2-hydroxy-4-methoxybenzophenone, 2-hydroxy-4-n-dodecyloxybenzophenone, 2,4-dihydroxybenzophenone, 2,2'-dihydroxy-4-methoxybenzophenone, and 2-hydroxy-4-n-octoxybenzophenone. Further, the compounded amount of the benzophenone-based ultraviolet absorber is preferably 0.01 to 5 parts by mass based on 100 parts by mass of the ethylene-polar monomer copolymer.

In addition, also with the containing of a light stabilizer, the ethylene-polar monomer copolymer can be suppressed from the degradation under the influence of irradiated light or the like, and the sealing film can be suppressed from turning yellow. As the light stabilizer, a light stabilizer called a hindered amine-based is preferably used, and for example, examples of the light stabilizer include LA-52, LA-57, LA-62, LA-63LA-63p, LA-67, and LA-68 (these are all manufactured by ADEKA CORPORATION); Tinuvin 744, Tinuvin 770, Tinuvin 765, Tinuvin 144, Tinuvin 622LD, and CHIMASSORB 944LD (these are all manufactured by BASF); and UV-3034 (manufactured by

B.F.Goodrich). Further, the light stabilizer may be used alone or two or more kinds in combination, and the compounded amount is preferably 0.01 to 5 parts by mass based on 100 parts by mass of the ethylene-polar monomer copolymer.

Examples of the age resister include, for example, a hindered phenol-based antioxidant such as N,N'-hexane-1,6-diylbis[3-(3,5-di-tert-butyl-4-hydroxypheny l)propionamide], a phosphorus-based heat stabilizer, a lactone-based heat stabilize, a vitamin E-based heat stabilizer, and a sulfur-based heat stabilizer.

### [Formation of sealing film for solar cells]

The above-described sealing film for solar cells of the present invention maybe formed in accordance with a known method.

For example, the sealing film for solar cells of the present invention can be produced by a method in which a composition obtained by the mixture of each of the materials described above by a known method using a super mixer (high-speed fluidizing mixer), a roll mill, or the like is molded with ordinary extrusion molding, calendar molding (calendering), or the like to obtain a sheet-shaped product. Further, a sheet-shaped product can also be obtained by the dissolving of the composition into a solvent, and the coating of the resultant solution on an appropriate support with a coating machine (coater), and the drying of the resultant coating to form a coating film. In addition, the heating temperature at the time of forming a film is preferably a temperature at which a cross-linking agent does not react or hardly reacts. For example, a temperature of 50 to 90°C is preferred, and a temperature of 40 to 80°C is particularly preferred. The thickness of the sealing film for solar cells before crosslinking curing can appropriately be adjusted depending on the formulation of the composition in order to form a sealing film for solar cells with the above-mentioned value of ρv·t after crosslinking curing. In consideration of the workability, the thickness of the sealing film for solar cells before crosslinking curing is preferably 0.4 to 2.0 mm (the thickness of the sealing film for solar cells after crosslinking curing is preferably 0.4 to 1.0 mm).

### [Solar cell module]

The structure of the solar cell module of the present invention is not particularly limited as long as being a structure in which a sealing film for solar cells with the above-mentioned value of ρv·t (that is, a sealing film for solar cells of the present invention) is disposed between the solar cell element (containing monocrystalline or polycrystalline silicon crystal-based cells for solar cell, and the power generation element for thin film solar cells) and the front side transparent protective member and/or the back side protective member, and is used to seal the solar cell element. In order to sufficiently seal a solar cell element in a solar cell module, for example, as shown in Fig. 1, a front side transparent protective member 11, a front side sealing film 13A, cells for solar cell 14 (connected plurally by an inter connector 15), a back side sealing film 13B, and a back side protective member 12 are laminated, and the sealing films may be crosslinked and cured according to a routine procedure such as heat pressing.

In the solar cell module of the present invention, the sealing film for solar cells with the above-mentioned value of ρv·t can be used for both of a front side sealing film 13A and a back side sealing film 13B, and as shown in Examples (Reference Examples) described below, particularly in a case of being used for a front side sealing film 13A, the sealing film for solar cells is preferred because the generation of PID phenomenon in the solar cell module can be more effectively prevented.

Therefore, in the solar cell module of the present invention, as the back side sealing film 13B, a sealing film for solar cells with the above-mentioned value of ρv·t may be used, and another known sealing film for solar cells that is suitable for a back side sealing film can also be used.

In order to perform the heat pressing, for example, the laminated body may be press-bonded under heating at a temperature of 135 to 180°C, further 140 to 180°C, and particularly 155 to 180°C, for a degassing time of 0.1 to 5 minutes, under a pressing pressure of 0.1 to 1.5 kg/cm², for a pressing time of 5 to 30 minutes by a vacuum laminator. During the heat-pressing, by the crosslinking of an ethylene-polar monomer copolymer such as an EVA contained in the front side sealing film 13A and the back side sealing film 13B, a front side transparent protective member 11, a back side transparent member 12, and cells for solar cell 14 (connected plurally by an interconnector 15) are integrated via a front side sealing film (after crosslinking curing) 13Ac and a back side sealing film (after crosslinking curing) 13Bc as shown in Fig. 2, and the cells for solar cell 14 can be sealed.

Further, the solar cell module of the present invention may be a thin film solar cell module such as a thin film silicon-based or thin film amorphous silicon-based solar cell module, and a copper indium selenide (CIS)-based solar cell module, in which a sealing film for solar cells with the above-mentioned value of ρv·t has been used as the sealing film. In this case, for example, a bonded and integrated structure in which a back side sealing film, a back side protective member are laminated on a thin film solar cell element layer formed on a surface of a front side transparent protective member such as a glass substrate, a polyimide substrate, and a fluororesin-based transparent substrate by a chemical vapor deposition method and the like; a bonded and integrated structure in which a front side sealing film, and a front side transparent protective member are laminated on a thin film solar cell element formed on a surface of a back side protective member; and a bonded and integrated structure in which a front side transparent protective member, a front side sealing film, a thin film solar cell element, a back side sealing film, and a back side protective member are laminated in this order, are included. In a case of also a thin film solar cell module, a structure in which a sealing film for solar cells with the above-mentioned value of ρv·t is used as the front side sealing film is preferred.

The front side transparent protective member 11 used for a solar cell module may usually be a glass substrate made of silicate glass and the like. The thickness of the glass substrate is generally 0.1 to 10 mm, and preferably 0.3 to 5 mm. The glass substrate may generally be a glass substrate reinforced chemically or thermally.

For the back side protective member 12, a plastic film such as polyethylene terephthalate (PET) is preferably used. Further, in consideration of the heat resistance and the moist heat resistance, a polyfluoroethylene film, particularly a film of the polyfluoroethylene film / Al / polyfluoroethylene film laminated in this order is also preferred.

For the interconnector 15, copper foil and the like to which solder plating and the like are performed are usually used.

Further, the solar cell module is usually attached with a frame 16 in order to enhance the mechanical strength as shown in Fig. 2. For the frame 16, generally an aluminum-based frame is used.

In the solar cell module of the present invention, the preferred embodiment of the sealing film for solar cells with the above-mentioned value of ρv·t is the same as that in a case of the sealing film for solar cells of the present invention described above.

In addition, the solar cell module of the present invention is, as described above, characterized by having a structure in which a solar cell element is sealed using a sealing film for solar cells with the above-mentioned value of ρv·t. Therefore, the other members except for the sealing film for solar cells, such as the front side transparent protective member, the back side protective member, the solar cell element, and the frame may have the same constitution as that of conventionally known solar cells, and are not particularly limited.

### [Selecting method of sealing film for solar cells]

The method for selecting a sealing film for solar cells is a method in which a sealing film for solar cells that is used for a solar cell module constituting a solar power generation system with a system voltage of 600 V or more and can suppress the generation of PID phenomenon is selected among the sealing films for solar cells obtained by crosslinking curing the composition containing an ethylene-polar monomer copolymer and a crosslinking agent. Further, the method is characterized by measuring a volume resistivity of (pv [Ω·cm]) (in accordance with JIS K6911-1995) of a sealing film for solar cells at a temperature of 25°C after crosslinking curing, and a thickness (t [cm]) of the sealing film for solar cells; and selecting a sealing film for solar cells having the product (ρv·t) of the volume resistivity (ρv) and the thickness (t) of 5.0 × 10¹³ or more. According to this, a sealing film for solar cells having high insulation with the predetermined level or more can be selected. The sealing film for solar cells with the value of ρv·t of 7.0×10¹³ or more, and further 1.0 × 10¹⁴ or more is preferably selected.

In the present invention, in order to determine the value of ρv·t of the sealing film for solar cells after crosslinking curing, a sample of the sealing film that has been crosslinked and cured under the same conditions as the crosslinking conditions at the time of preparing the solar cell module is used. Specifically, for example, a sheet of the sealing film for solar cells before crosslinking curing is sandwiched between two release films, and crosslinked and cured under heat-pressing conditions of a laminated body of the solar cell module, after that, with the sample removed the release films, a volume resistivity of (pv) is measured in accordance with JIS K6911-1995 at a temperature of 25°C, and a thickness (t) of the sealing film for solar cells is measured by using a thickness measuring machine or the like that are usually used. The measurement of the volume resistivity (pv) is preferably measured by a model corresponding to the measurement in a high-resistance region. For example, the measurement can be performed by using Hiresta UP Model MCP-HT450 (manufactured by Mitsubishi Chemical Analytech Co., Ltd.), and a measurement probe UR-100.

In addition, in the selecting method described above, for the sealing film for solar cells with the value of ρv·t of 5.0 × 10¹³ (preferably 7.0 × 10¹³ and more preferably 1.0 × 10¹⁴), the resistance value (R [Ω]) in the film thickness direction, which is obtained at the time of the measurement of the volume resistivity, is recorded as a reference value, and for the sample of the sealing films for solar cells to be selected therefrom, the resistance value (R) is measured under the same conditions, subsequently the sealing film for solar cells having a resistance value (R) of the reference value or more can also be selected. The measurement of the film thickness can be omitted, and the sealing film for solar cells can more easilybe selected. Further, the measured value of the resistance value (R) has a different value depending on the measurement apparatus, the measurement probe, the measurement temperature, and the like, therefore, the measured values are numerical values that can compare only among the resistance values (R) measured under the same conditions.

### Examples

Hereinafter, the present invention will be explained by way of Examples.

### [Examples 1 to 4, Comparative Examples 1 to 6]

Each material in the formulation shown in Table 1 was supplied to a roll mill, and the kneading was performed at 70 to 100°C to prepare a sealing film composition for solar cells. The sealing film composition for solar cells was calendar molded at 70 to 100°C, and after standing to cool, the sealing film for solar cells (before crosslinking curing) was prepared. Sealing films for solar cells were prepared so that the thickness of each sealing film is the thickness shown in Table 1 after crosslinking curing.

Next, each sealing film was used as the front side sealing film, and the back side sealing film, the cells for solar cell were sandwiched between the front side transparent protective member (glass plate) and the back side protective member (PET film), and a solar cell mini module in which four cells for solar cell had been connected (see Figs. 1 and 2) was prepared. The press-bonding under heating was performed under heat-pressing conditions of at a temperature of 155°C, for a degassing time of 5 minutes, under a pressing pressure of 1.0 kg/cm², for a pressing time of 30 minutes by a vacuum laminator.

Further, each sealing film (size: 100 mm × 100 mm) was sandwiched between two release PET films, and the press-bonding under heating was performed under the same conditions to prepare a sample for measuring a volume resistivity (pv [Ω·cm]) and a thickness (t [cm]) of the sealing film for solar cells after crosslinking curing.

### [Reference Examples 1 and 2]

In order to examine the difference between the effects in a case where the sealing film of the present invention was used for the front side sealing film and in a case where the sealing film of the present invention was used for the back side sealing film, as shown in Table 2, a solar cell mini module was prepared using a different sealing film for each of the front side sealing film and the back side sealing film.

### [Evaluation method]

### (1) Output retention rate (%)

As the model test to generate PID phenomenon, each of the prepared solar cell mini modules was immersed with the photoreception surface side being the bottom side in a water tank, and at a temperature of 60°C and a relative humidity of 85%, an output terminal of a short-circuitedmodule was connected to a negative electrode, and the positive electrode was connected to a copper plate disposed in the water tank, and a voltage of 1,000 V was applied for 24 hours.

Before and after the test, the maximum output (Pₘₐₓ) of each solar cell mini module was measured, and the output retention rate ((Pₘₐₓ after test / Pₘₐₓ before test) × 100 (%)) was calculated.

For the a solar cell mini module having an output retention rate of 98% or more, the above-mentioned test was further performed at a temperature of 85°C under the same conditions as those except for the temperature condition.

When the output retention rate was 98% or more at both temperatures of 60°C and 85°C, it was judges as ○; when the output retention rate was 98% or more at a temperature of 60°C and when the output retention rate was less than 98% at a temperature of 85°C, it was judges as Δ; and when the output retention rate was less than 98% at a temperature of 60°C, it was judges as X. The results are shown in Table 1.

### (2) Volume resistivity (pv)

For the sample of the sealing film for solar cells after crosslinking curing, the volume resistivity (pv [Ω·cm]) was measured at 25°C in accordance with JIS K6911-1995 by using Hiresta UP Model MCP-HT450 (manufactured by Mitsubishi Chemical Analytech Co., Ltd.), and a measurement probe UR-100. The results are shown in Table 1. Further, the resistance value (R [Ω]) measured by the same apparatus was described together.

### (3) Thickness (t)

For the sealing film for solar cells after crosslinking curing, the thickness (t [cm]) was measured by using a thickness measuring machine (micrometer). The results are shown in Table 1.

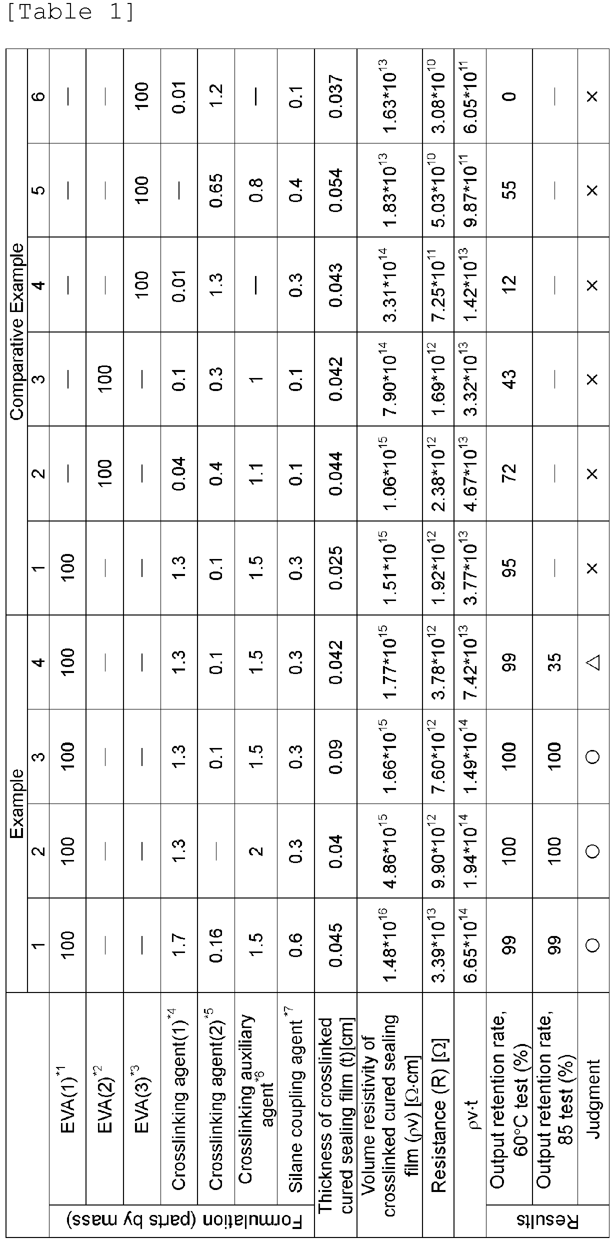

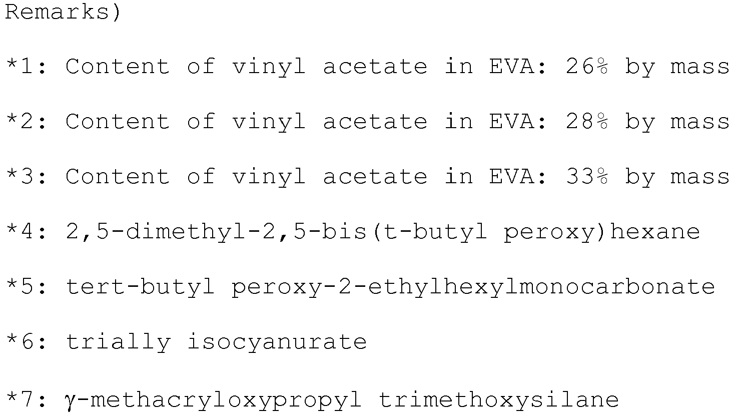

[Table 2]

**[Table 2]**

| | | Reference Example 1 | Reference Example 2 |
|---|---|---|---|
| Constitution of sealing film | Front side sealing film | Sealing film of Example 3 | Sealing film of Comparative example 4 |
| | ρv·t | 1.49*10¹⁴ | 1.42*10¹³ |
| | Back side sealing film | Sealing film of Comparative example 4 | Sealing film of Example 3 |
| | ρv·t | 1.42*10¹³ | 1.49*10¹⁴ |
| Evaluation results | Output retention rate, 60°C test (%) | 99 | 37 |

### [Evaluation results]

From the evaluation results of the output retention rate of each solar cell mini module, it was recognized that the generation of PID phenomenon was suppressed in the solar cell mini module using a sealing film with the value of ρv·t of the sealing film for solar cells after crosslinking curing of 5.0 × 10¹³ or more. Further, the suppressive effect on the generation of PID phenomenon in Example 4 was slightly deteriorated, therefore, it was indicated that a sealing film with the value of ρv·t of 1.0 × 10¹⁴ or more is more preferred.

In addition, from the Reference Examples 1 and 2, it was found that the sealing film for solar cells of the present invention can more effectively prevent the generation of PID phenomenon of a solar cell module in a case of being used particularly for the front side sealing film.

Further, the present invention is not limited to the constitution of the above-mentioned embodiment and Examples, and can be variously modified within the scope of the gist of the invention.

### Industrial Applicability

According to the present invention, in a solar cell module constituting a solar power generation system with a high system voltage, a sealing film for solar cells capable of suppressing the generation of PID phenomenon is provided, and the present invention can contribute to the stabilization of the power generation output in the large-scale solar power generation system.

### Reference Signs List

- 11: Front side transparent protective member
- 12: Back side protective member
- 13A: Front side sealing film
- 13B: Back side sealing film
- 14: Cells for solar cell
- 15: Interconnector
- 16: Frame

## Claims

1. A sealing film for solar cells being used for a solar cell module constituting a solar power generation system with a system voltage of 600 V or more, comprising:
a crosslinkable and curable film of a composition containing an ethylene-polar monomer copolymer and a crosslinking agent,
wherein, after crosslinking and curing of a sealing film for solar cells,a product (ρv·t) of a volume resistivity (pv [Ω·cm]) at 25°C (in accordance with JIS K6911-1995) of the sealing film and a thickness (t [cm]) of the sealing film is 5.0 × 10¹³ or more.

2. The sealing film for solar cells according to Claim 1,
wherein the system voltage of the solar power generation system is 1,000 V or more.

3. The sealing film for solar cells according to Claim 1 or 2,
wherein the ethylene-polar monomer copolymer is an ethylene-vinyl acetate copolymer.

4. The sealing film for solar cells according to any one of Claims 1 to 3,
wherein the crosslinking agent is an organic peroxide.

5. The sealing film for solar cells according to any one of Claims 1 to 4,
wherein the composition further contains a crosslinking auxiliary agent and/or a silane coupling agent.

6. The sealing film for solar cells according to any one of Claims 1 to 5,
wherein the sealing film for solar cells after crosslinking and curing has a thickness of 0.4 to 1.0 mm.

7. The sealing film for solar cells according to any one of Claims 1 to 6,
wherein the sealing film for solar cells is a front side sealing film being disposed between a solar cell element and a front side transparent protective member of a solar cell module, and used for sealing the solar cell element.

8. A solar cell module, comprising:
constituting a solar power generation system with a system voltage of 600 V or more; and
having a structure of disposing a sealing film for solar cells between a solar cell element and a front side transparent protective member and/or between the solar cell and a back side protective member, and of sealing the solar cell element by the sealing film for solar cells,
wherein the sealing film for solar cells consists of a crosslinked cured film of a composition containing an ethylene-polar monomer copolymer and a crosslinking agent, and
a product (ρv·t) of a volume resistivity (pv [Ω·cm]) at 25°C (in accordance with JIS K6911-1995) of the sealing film for solar cells after crosslinking curing and a thickness (t [cm]) of the sealing film for solar cells after crosslinking and curing is 5.0 × 10¹³ or more.

9. The solar cell module according to Claim 8,
wherein the system voltage of the solar power generation system is 1,000 V or more.

10. The solar cell module according to Claim 8 or 9,
wherein the solar cell module has a structure of disposing the sealing film for solar cells as a front side sealing film between the solar cell element and the front side transparent protective member, and of sealing the solar cell element by the front side sealing film.

11. The solar cell module according to any one of Claims 8 to 10,
wherein the ethylene-polar monomer copolymer is an ethylene-vinyl acetate copolymer.

12. The solar cell module according to any one of Claims 8 to 11,
wherein the crosslinking agent is an organic peroxide.

13. The solar cell module according to any one of Claims 8 to 12,
wherein the composition of the sealing film for solar cells further contains a crosslinking auxiliary agent and/or a silane coupling agent.

14. The solar cell module according to any one of Claims 8 to 13,
wherein the sealing film for solar cells after crosslinking curing has a thickness of 0.4 to 1.0 mm.

15. A method for selecting a sealing film for solar cells being obtained by crosslinking and curing a composition containing an ethylene-polar monomer copolymer and a crosslinking agent, and used for a solar cell module constituting a solar power generation system with a system voltage of 600 V or more, comprising:
measuring a volume resistivity (pv [Ω·cm]) at 25°C (in accordance with JIS K6911-1995) of a sealing film for solar cells after crosslinking curing, and a thickness (t [cm]) of the sealing film for solar cells after crosslinking curing; and
selecting a sealing film for solar cells having a product (ρv·t) of the volume resistivity (pv) and the thickness (t) of 5.0 × 10¹³ or more.
